# FASCICULE DE BREVET EUROPEEN

(11) **EP 2 795 490 B1**
(45) Date de publication et mention de la délivrance du brevet: **13.07.2022**
(21) Numéro de dépôt: 12805692.6
(22) Date de dépôt: 19.12.2012
(51) Int. Cl.: G06F 30/20, G06F 30/23

(54) **MACHINE ET PROCEDE D'EVALUATION DE COMPORTEMENT DE CONFIGURATIONS D'UN COMPOSANT**
SYSTEM UND VERFAHREN ZUR BEURTEILUNG DES VERHALTENS VON KONFIGURATIONEN EINER KOMPONENTE
SYSTEM AND METHOD FOR ASSESSING THE BEHAVIOR OF THE CONFIGURATIONS OF A COMPONENT

(30) Priorité: 21.12.2011 FR 1162144; 21.12.2011 FR 1162145
(43) Date de publication de la demande: 29.10.2014
(73) Titulaire: Renault s.a.s, 92100 Boulogne Billancourt (FR)
(72) Inventeur: VAUMORON, Pascal, F-78340 Les Clayes Sous Bois (FR); CHATILLON, Marie-Maud, F-78180 Montigny Le Bretonneux (FR)
(74) Mandataire: Renault Group
(86) Numéro de dépôt international: PCT/EP2012/076211
(87) Numéro de publication internationale: WO 2013/092748

(56) Documents cités:
- Rodenburg, R R P et al.: "Development of a Generic Vehicle Modelling Procedure", Conference of Crash, ICrash 2006, Athens Greece, 4th-7th July 2006 , 7 juillet 2006 (2006-07-07), pages 1-12, XP002681144, Extrait de l'Internet: URL:http://mate.tue.nl/mate/pdfs/6943.pdf [extrait le 2012-08-01]
- LUÃS SOUSA ET AL: "Development of generic multibody road vehicle models for crashworthiness", MULTIBODY SYSTEM DYNAMICS, KLUWER ACADEMIC PUBLISHERS, DO, vol. 19, no. 1-2, 20 septembre 2007 (2007-09-20), pages 133-158, XP019578807, ISSN: 1573-272X
- YANG R J ET AL: "Shape optimization of connecting rod pin end using a generic model", FINITE ELEMENTS IN ANALYSIS AND DESIGN 1992 JUL, vol. 11, no. 3, juillet 1992 (1992-07), pages 257-264, XP002681145, DOI: DOI:10.1016/0168-874X(92)90056-I
- ANDRIC J ET AL: "The global structural response model for multi-deck ships in concept design phase", OCEAN ENGINEERING, PERGAMON, AMSTERDAM, NL, vol. 37, no. 8-9, 1 juin 2010 (2010-06-01) , pages 688-704, XP027039751, ISSN: 0029-8018 [extrait le 2010-02-12]
- GERLACH G ET AL: "Strategies of modelling and simulation of microsystems with electromechanical energy conversion", MICROELECTRONICS JOURNAL, MACKINTOSH PUBLICATIONS LTD. LUTON, GB, vol. 29, no. 11, 1 novembre 1998 (1998-11-01), pages 773-783, XP004129261, ISSN: 0026-2692, DOI: 10.1016/S0026-2692(97)00091-8
- JORGE AMBRÓSIO ET AL: "Improved bushing models for general multibody systems and vehicle dynamics", MULTIBODY SYSTEM DYNAMICS, KLUWER ACADEMIC PUBLISHERS, DO, vol. 22, no. 4, 17 juin 2009 (2009-06-17), pages 341-365, XP019752222, ISSN: 1573-272X, DOI: 10.1007/S11044-009-9161-7

## Description

L'invention concerne une machine et un procédé d'évaluation de comportement de configurations d'un composant, plus particulièrement d'un composant mécanique de véhicule terrestre, aérien ou maritime.

La machine et le procédé sont utiles pour gagner du temps dans la conception du composant sous contraintes de performance au sein d'un système, notamment d'un système de véhicule automobile en mode écrasement (crash en anglais), vibratoire, statique ou autre.

La machine et le procédé sont aussi utiles pour systématiser la conception d'un ensemble de composants adaptés chacun à un système différent, notamment d'un ensemble de pièces structurelles pour des systèmes liés à différents projets de véhicules et à différents jalons des projets à coût d'ingénierie minimal.

Les constructeurs de systèmes, notamment les constructeurs de véhicules automobiles éprouvent le besoin de réduire le coût et le délai de conception d'un nouveau véhicule afin de répondre le mieux possible aux exigences des clients. Pour atteindre cet objectif, les équipes d'ingénierie ont généralement recours massivement à la simulation numérique afin d'évaluer plus rapidement les solutions techniques proposées par les bureaux d'études. Le calcul est particulièrement efficace dans la recherche de compromis techniques et oriente les concepteurs vers les modifications à apporter pour l'atteinte du cahier des charges.

Habituellement, la construction des modèles de calcul est réalisée manuellement par des spécialistes calcul et la durée de mise en oeuvre est souvent incompatible avec le nombre de solutions à étudier. L'externalisation des modèles, alors nécessaire pour lisser l'activité calcul, retarde également les délais de restitution des résultats des calculs et pénalise la réactivité des personnes dans les projets. Les compétences requises pour la construction des modèles, imposent la disponibilité croisée d'ingénieurs pour la partie technique et de concepteurs pour la partie esthétique ou fonctionnelle.

Un besoin se fait sentir pour remplacer les interventions manuelles par une automatisation des tâches liées à la construction des modèles.

Parmi les solutions connues de l'état antérieur de la technique, le brevet EP0397904B1 tel que publié le 27 juillet 1994, divulgue par exemple un procédé de génération de modèles graphiques d'objets comportant un ordre de réplications dont le nombre et les emplacements sont définis comme variables remplacées ensuite par des valeurs réelles.

Le brevet EP1298596B1 tel que publié plus récemment le 1er juin 2005, divulgue par exemple encore un procédé de métamorphose (morphing method en anglais) d'une forme basée sur une méthode par éléments finis d'un prototype de structure en déplaçant une pluralité de nœuds et en redéfinissant les informations qui concernent la méthode par éléments finis après déformation.

Le brevet EP1861752B1 tel que publié encore plus récemment le 4 mai 2011, divulgue un procédé dans lequel on modifie au moins une entrée de manière itérative jusqu'à approcher une sortie optimale. Les procédés basés sur des méthodes par essai erreur ont pour inconvénient lorsqu'ils sont appliqués à un modèle de simulation numérique de comportement, d'être couteux en temps de calcul par ordinateur et en temps humain dans la mesure où ils nécessitent de modifier le modèle après simulation et à relancer un calcul après modification jusqu'à converger vers un résultat satisfaisant.

Le modèle générique multicorps divulgué dans la publication de Luâs Souse et al: "Development of generic multibody road vehicle models for crashworthiness", Multi-body system dynamics, vol. 19, no. 1-2, pages 133-158 est basé sur un modèle détaillé par éléments finis (FE) d'un modèle générique de voiture. Ces modèles de véhicules sont qualifiés de génériques parce qu'ils ne représentent pas nécessairement des véhicules existants, mais ils contiennent tous les éléments structurels de véhicules réels et leur réaction en cas d'accident est la même que celle des véhicules existants sélectionnés. Étant donné que la topologie structurelle d'un modèle de véhicule générique comprend tous les éléments structurels de n'importe quel véhicule, de la même classe, il peut être modifié pour devenir le modèle exact d'un tel véhicule sans effort majeur.

Les procédés connus présentent de nombreux inconvénients. Notamment, la géométrie à calculer transférée comme une instance morte de CAO (acronyme de Conception Assistée par Ordinateur), en d'autres termes sans historique, oblige l'ingénieur calcul à ré intervenir dans la réalisation de la boucle numérique à la suite des modifications de forme géométrique. La définition géométrique est sous la responsabilité du bureau d'étude et l'évaluation de la performance est prise en charge par le secteur calcul. Conception et modélisation sont réalisées de manière manuelle et séquentielle sans connaissance pour un intervenant des outils utilisés par l'autre intervenant. Le temps de mise en oeuvre de la modélisation et le temps de restitution du résultat dépendent de la disponibilité des deux intervenants. Parfois le recours à la sous-traitance augmente de manière sensible le délai de chaque boucle numérique.

En général un seul domaine physique est évalué pour chaque calcul. A titre d'exemple, pour un modèle simple et pour une prestation écrasement de véhicule automobile, le temps d'intervention de la mise en place des conditions limites, cumulé avec celui de la simulation et du post-traitement, est de l'ordre de douze heures. Le délai de chaque calcul réduit donc le nombre de variantes à explorer, souvent nombreuses dans la phase amont d'un projet. La quantité de ressources disponibles limite le nombre de configurations possibles à évaluer. Pour chaque nouvelle proposition, le délai de préparation du calcul se réitère de manière quasi identique car beaucoup de tâches restent manuelles.

Compte tenu des inconvénients de l'état antérieur de la technique, l'invention a pour but de :
- réduire le délai de conception pour l'étude d'une variante d'une pièce sans avoir à recréer manuellement un modèle descriptif de cette variante ;
- réduire les tâches manuelles réalisées pour la construction d'un modèle de calcul ;
- simplifier la mise en oeuvre de la boucle calcul grâce à une automatisation de celle-ci à partir de spécifications présentes dans la CAO ;
- réduire les coûts d'ingénierie ;
- pouvoir balayer un nombre élevé de solutions techniques en vue d'assurer un niveau de prestation demandée ;
- permettre à une personne non spécialiste de modifier une géométrie et de lancer la réalisation du volet calcul ;
- intégrer des critères multi-prestations dans la CAO pour traiter en même temps des domaines physiques différents, par exemple écrasement et banc vibroacoustique (NVH).

On connaît déjà les langages formels qui sont des moyens techniques de spécifications de composants en grand nombre qui en permettent un traitement par une machine informatique.

Par exemple le brevet EP1027648B1 tel que publié le 12 décembre 2007, porte sur des tests de générateur de langage de description de matériel permettant d'élaguer des productions correspondant à des tests qui ont échoués.

Par exemple encore, le brevet EP0979568B1 tel que publié le 12 septembre 2007, porte sur un procédé de transmission d'informations dont la structure est définie par un langage formel spécifique pour définir des structures de données, dans lequel la transmission intervient sous forme de texte codé.

Cependant, les procédés connus de l'état de la technique des langages formels, ne prennent pas en compte les contraintes liées à des composants mécaniques, notamment des composants mécaniques de véhicules automobiles. Ils posent donc de nombreux problèmes, notamment pour prendre en compte ces contraintes de manière automatique ou encore pour contrôler par une machine le respect de ces contraintes dans toute intervention humaine.

Pour remédier aux problèmes de l'état antérieur de la technique, l'invention a pour objet une machine d'évaluation de comportement en absorption d'énergie de chocs d'une ou plusieurs configurations d'une traverse constituant un composant mécanique de véhicule au moyen d'au moins un logiciel de conception assistée par ordinateur, caractérisée en ce qu'elle comprend :
- une zone mémoire contenant un modèle générique en langage formel de ladite traverse, ledit modèle générique comprenant un paramétrage de formes en associant à tout ou partie des valeurs géométriques de formes d'un modèle de base, des paramètres de formes variables dans des plages prédéterminées, les valeurs géométriques de forme définissant des surfaces auxquelles on applique une fonction de nommage, ladite fonction de nommage attribuant par convention de nommage de manière arborescente un nom univoque à chaque surface, à chaque valeur de forme étant associée respectivement un des paramètres de profondeur, de demi-section droite, de demi-longueur, d'angle de galbe intérieur et extérieur pour définir ladite traverse dans des dimensions de grandeurs géométriques, des règles de contrôle de valeurs des dits paramètres entre des limites hautes et des limites basses, et une spécification de simulation de comportement en absorption d'énergie de chocs de ladite traverse en fonction des dits paramètres ;
- une première séquence d'instructions informatiques de génération automatique d'une pluralité de modèles individuels chacun associé à une configuration de ladite traverse en affectant aux paramètres du modèle générique des valeurs de configuration contrôlées par lesdites règles à partir d'au moins une ligne de valeurs d'entrée attribuables pour chaque paramètre pour chaque configuration à évaluer; avec stockage au fur et à mesure de chaque modèle individuel de configuration dans un fichier informatique;

- une deuxième séquence d'instructions informatiques de lancement de simulations numériques de comportement en absorption d'énergie de chocs des modèles individuels au moyen de ladite spécification, ladite deuxième séquence d'instructions lance de manière automatique et indépendante de la première séquence les simulations des modèles individuels en chargeant dans un ordinateur successivement l'un des fichiers stockés par la première séquence et lorsque le rythme des fichiers stockés par la première séquence, est plus rapide que celui d'une simulation par un. ordinateur, la deuxième séquence répartit le chargement des fichiers des modèles individuels sur plusieurs ordinateurs de simulations, le ou les ordinateurs de simulation stockant à leur tour les résultats de chaque simulation dans un fichier informatique; et
- une troisième séquence d'instructions informatiques de traitement pour produire à partir desdites simulations une ou plusieurs valeurs d'évaluation du comportement en absorption d'énergie de chocs de la chaque configuration à laquelle est associé un modèle individuel, la troisième séquence d'instructions traitant au moins un critère de performance de manière automatique, dès que la deuxième séquence sort un résultat de simulation ou après que la deuxième séquence a sorti tous les résultats de simulation.

Particulièrement, d'une part la séquence d'instructions informatiques de lancement comprend un ensemble d'instructions informatiques de maillage dudit modèle individuel et un ensemble d'instructions informatiques d'activation d'un logiciel de simulation par éléments finis, et d'autre part la spécification de simulation contient des instructions qualificatives de maillage.

Plus particulièrement aussi, la séquence d'instructions informatiques de lancement comprend un ensemble d'instructions informatiques de traduction pour transcrire automatiquement le modèle individuel tel qu'il est généré dans un format lisible par la suite de la séquence d'instructions informatiques de lancement de la simulation numérique.

Avantageusement, la séquence d'instructions informatiques de lancement comprend un ensemble d'instructions informatiques de mise en données du modèle individuel à partir de la spécification de simulation pour fournir un modèle spécifique à la simulation numérique.

Particulièrement, la spécification de simulation comporte des lois physiques de comportement en écrasement.

De préférence, la séquence d'instructions informatiques de traitement produit la ou les valeurs d'évaluation du comportement de la configuration en comparant des résultats de ladite simulation à des critères de performance contenus dans ladite spécification de simulation.

De façon particulièrement avantageuse, la machine est agencée pour affecter les paramètres à des entités de la traverse comportant au moins une poutre et une boîte d'écrasement, en suivant une convention de nommage partagée par les règles de contrôle et la spécification de simulation.

L'invention a aussi pour objet un procédé d'évaluation de comportement en absorption d'énergie de chocs d'une pluralité de configurations d'une traverse constituant un composant mécanique de véhicule au moyen d'au moins un logiciel de conception assistée par ordinateur, caractérisé en ce qu'il comprend des étapes consistant à :
- obtenir un modèle générique en langage formel de ladite traverse, la construction dudit modèle générique comprenant un paramétrage de formes en associant à tout ou partie des valeurs géométriques de formes d'un modèle de base, des paramètres de formes variables dans des plages prédéterminées, les valeurs géométriques de forme définissant des surfaces auxquelles on applique une fonction de nommage, ladite fonction de nommage attribuant par convention de nommage de manière arborescente un nom univoque à chaque surface, à chaque valeur de forme est associée respectivement un paramètre de profondeur, de demi-section droite, de demi-longueur, d'angle de galbe intérieur et extérieur, pour définir ladite traverse dans des dimensions de grandeurs géométriques, des règles de contrôle de valeurs des dits paramètres entre des limites hautes et des limites basses et une spécification de simulation de comportement en absorption d'énergie de chocs de ladite traverse en fonction des dits paramètres ;
- établir une ligne de valeurs des paramètres pour chaque configuration à évaluer ;
- soumettre le modèle générique obtenu et la ou les lignes de valeurs établies à une machine comprenant :
   - une première séquence d'instructions informatiques de génération automatique d'une pluralité de modèles individuels chacun associé à une configuration de ladite traverse en affectant aux paramètres du modèle générique des valeurs de configuration contrôlées par les dites règles à partir d'au moins une ligne de valeurs d'entrée, avec stockage au fur et à mesure de chaque modèle individuel de configuration dans un fichier informatique;
   - une deuxième séquence d'instructions informatiques de lancement automatique de simulations numériques de comportement en absorption d'énergie de chocs des modèles individuels au moyen de ladite spécification, ladite deuxième séquence d'instructions lançant de manière automatique et indépendante de la première séquence les simulations des modèles individuels en chargeant dans un ordinateur successivement l'un des fichiers stockés par la première séquence et lorsque le rythme des fichiers stockés par la première séquence, est plus rapide que celui d'une simulation par un. ordinateur, la deuxième séquence répartit le chargement des fichiers des modèles individuels sur plusieurs ordinateurs de simulations, le ou. les ordinateurs de simulation stockant à leur tour les résultats de chaque simulation dans un fichier informatique ; et
   - une troisième séquence d'instructions informatiques de traitement pour produire à partir desdites simulations, une ou plusieurs valeurs d'évaluation du comportement en absorption d'énergie de chocs de chaque configuration à laquelle est associé un modèle individuel, la troisième séquence d'instructions traitant au moins un critère de performance de manière automatique, dès que la deuxième séquence sort un résultat de simulation ou après que la deuxième séquence a sorti tous les résultats de simulation.

Particulièrement, l'étape consistant à obtenir le modèle générique comprend des actions consistant à :
- produire au moyen d'un premier logiciel de conception assistée par ordinateur des entités de type boîte d'écrasement par création de paramètres comprenant des paramètres les valeurs de forme d'une demi-largeur prise à partir d'une ligne de centrage située à distance déterminée d'une extrémité de la traverse, en identifiant les paramètres et les entités produites au moyen d'une convention de nommage ;
- établir les règles de contrôle en les associant, au moyen de la convention de nommage, aux entités produites ;
- construire le modèle générique en assemblant, au moyen de la convention de nommage, les entités produites, par création des paramètres dans deux plans orthogonaux pour définir, par projection inverse, l'entité dans un espace tridimensionnel.

Plus particulièrement, l'étape consistant à obtenir le modèle générique comprend une ou plusieurs actions consistant à élaborer la spécification de simulation de manière applicable aux entités au moyen de la convention de nommage.

Particulièrement, les paramètres comportent des paramètres de formes géométriques et en ce que le modèle générique comporte une structure arborescente d'entités comprenant des points, des lignes, des surfaces et/ou des volumes.

De manière particulièrement avantageuse, la spécification de simulation contient des instructions qualificatives de maillage.

D'autres caractéristiques et avantages apparaîtront à la lecture de la description qui suit, en référence aux dessins annexés dans lesquels :
- la figure 1 est un schéma de machine conforme à l'invention,
- la figure 2 montre une vue partielle 2D de modèle générique conforme à l'invention,
- la figure 3 montre une vue 3D de modèle générique conforme à l'invention,
- les figures 4 et 5 montrent des configurations de composant obtenues à partir du modèle générique de la figure 3,
- les figures 6 à 8 montrent des résultats de séquences d'instructions de la machine de la figure 1.

Un procédé qui utilise la machine conforme à l'invention, est utile pour évaluer, ou en d'autres termes pour mesurer, le comportement d'une configuration d'un composant sans avoir à réaliser un exemplaire physique du composant. Le procédé est particulièrement utile pour évaluer plusieurs configurations possibles du composant de façon par exemple à pouvoir les comparer ou à établir des versions différentes du composant en vue de son intégration dans différents systèmes. Par exemple, si le composant est une pièce de véhicule automobile, il est intéressant de connaître celle des configurations possibles qui est la plus appropriée à un type de véhicule donné en termes de performances. Il est intéressant aussi de pouvoir faire évoluer la configuration de la pièce pour l'adapter à un autre type de véhicule.

Une première étape du procédé consiste à obtenir un modèle générique du composant. Le modèle générique est une spécification qui décrit en langage formel les éléments essentiels du composant pour évaluer son comportement, notamment au moyen d'une simulation numérique, puis plus tard éventuellement pour établir des plans de fabrication.

On rappelle qu'un langage formel est un langage directement interprétable par une machine comme par exemple dans le cas d'un ordinateur, d'un automate, d'un appareil de restitution du son et d'images ou d'un outil à commande numérique. A titre illustratif, on peut citer non seulement les langages de programmation mais aussi les langages de structures de données comprenant les bases de données, les bases de connaissances ou encore les langages descriptifs tels que VHDL ou autres. Une spécification en langage formel est généralement difficile à interpréter par un être humain. Le langage formel comprend alors généralement des interfaces telles que des modules de présentations graphiques en deux ou trois dimensions, sous forme de tableaux renseignés ou autres qui permettent à l'être humain de comprendre et d'intervenir sur la spécification.

Par opposition à un modèle spécifique ou modèle individuel qui correspond à une configuration particulière du composant, le modèle est générique en ce qu'il appartient à la compréhension du genre du composant. Par exemple si le composant est une pièce structurelle de véhicule automobile, son modèle générique est celui qui caractérise une traverse extrême avant, une traverse extrême arrière, un longeron, ou autre de manière générale sans être spécifique à tel ou tel véhicule. Le modèle est aussi générique en ce qu'il permet de générer des modèles individuels, descriptif et prédictifs chacun d'un composant physique particulier.

Plus précisément, le modèle générique du composant conforme à l'invention comporte des paramètres, des règles de contrôle de valeurs des paramètres, et une spécification de simulation d'au moins un comportement du composant en fonction des paramètres. Les paramètres du modèle générique sont de nature géométrique pour désigner un point dans l'espace, une longueur, un rayon de courbure ou toute autre grandeur géométrique, de nature compositionnelle pour désigner un matériau, une propriété physique de matériau ou toute autre grandeur liée à la composition d'un élément du composant, ou de toute autre nature pour définir le composant dans une dimension de grandeurs autres que géométrique ou compositionnelle.

On peut prévoir d'obtenir le modèle générique prêt à l'emploi par exemple par accès à une base de données dans laquelle on a préalablement rendu disponibles des modèles génériques conformes à l'invention. On peut aussi prévoir d'obtenir le modèle générique prêt à l'emploi par exemple en le recevant d'un donneur d'ordre qui passe commande d'une détermination de comportements de différentes configurations d'un composant défini par le modèle générique.

Pour mieux comprendre ce que comporte le modèle générique conforme à l'invention, on décrit à présent, au sein de la première étape du procédé, un enchaînement d'actions par exemple manuelles, en d'autres termes réalisées par un ou plusieurs êtres humains avec l'appui de macro-instructions dans un outil de conception assistée par ordinateur.

A titre purement illustratif et non exhaustif, ces actions comprennent des actions de construction du modèle générique à partir d'un modèle de base.

Le modèle de base comprend des valeurs géométriques de formes par exemple d'un composant préexistant ou d'une configuration spécifique de composant en cours de conception.

La construction du modèle générique comprend un paramétrage de formes en associant à tout ou partie des valeurs géométriques de formes du modèle de base, des paramètres de formes variables dans des plages prédéterminées. Les plages dans lesquelles les paramètres de formes varient sont par exemple prédéterminées par des concepteurs en se fondant sur l'expérience acquise lors d'études précédentes par les intervenants des différents métiers nécessaires à l'élaboration de composants semblables.

Les valeurs géométriques de formes définissent des surfaces auxquelles on applique une fonction de nommage. La fonction de nommage attribue de manière arborescente un nom univoque à chaque surface. Le nom univoque est une chaîne de caractères comprenant une racine qui désigne le composant, éventuellement une sous racine qui désigne un élément du composant auquel appartient la surface et une feuille qui désigne la surface elle-même.

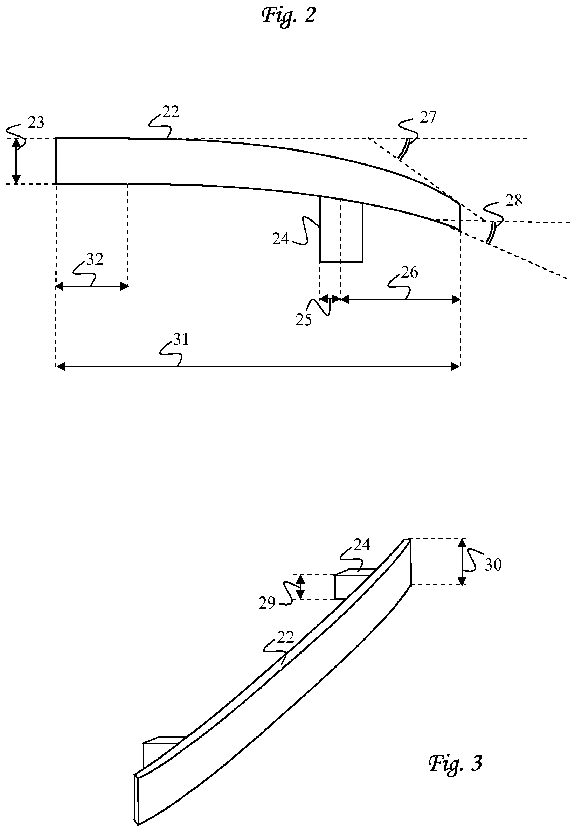

A titre purement illustratif et non exhaustif, la figure 2 montre une esquisse 2D, en d'autres termes une représentation graphique ou projection bidimensionnelle partielle d'un modèle, de demi-traverse extrême avant.

On rappelle qu'une traverse extrême avant est une pièce de véhicule automobile généralement symétrique prévue essentiellement pour absorber tout ou partie de l'énergie des chocs frontaux sur le véhicule.

Parmi les valeurs de formes visibles sur la figure 2 on peut citer relativement à une poutre 22, celles d'une profondeur, d'une demi-section droite, d'une demi-longueur, d'un angle de galbe extérieur et d'un angle de galbe intérieur. A chaque valeur de forme, on associe respectivement un paramètre de profondeur 23, un paramètre de demi-section droite 32, un paramètre de demi-longueur 31, un paramètre d'angle de galbe extérieur 27 et un paramètre d'angle de galbe intérieur 28, chacun désigné en conformité avec la convention de nommage. Un nom de paramètre comprend ainsi une chaîne de caractères désignant le composant « traverse extrême avant », suivie d'une chaîne de caractères désignant l'entité « poutre », suivie d'une chaîne de caractères désignant le type de paramètre « longueur », « profondeur », « angle » ou autre, terminé ou précédé par un numéro d'ordre qui garantit la propriété univoque de chaque nom de paramètre. On notera la généricité de la traverse offerte par le paramétrage adaptatif contextuel lié au processus de fabrication et au type de traverse.

On peut encore citer relativement à une boîte d'écrasement (crash box en anglais) 24, les valeurs de forme d'une demi-largeur prise à partir d'une ligne de centrage située à une distance déterminée d'une extrémité de la poutre 22. A chaque valeur de forme, on associe respectivement ici encore un paramètre de demi largeur 25 et un paramètre de distance 26 par rapport à une extrémité de la poutre. Le nom de chaque paramètre comprend alors une chaîne de caractères désignant le composant « traverse extrême avant », suivie d'une chaîne de caractères désignant l'entité « boîte d'écrasement », suivie d'une chaîne de caractères désignant le type de paramètre «demi largeur », « distance » ou autre, terminé ou précédé par un numéro d'ordre qui garantit la propriété univoque de chaque nom de paramètre.

A titre purement illustratif et non exhaustif encore, les actions effectuées comprennent des actions qui consistent à produire des entités telles que la poutre 22 et la boîte d'écrasement 24, au moyen d'un logiciel de conception assistée par ordinateur, en créant des paramètres qui définissent chaque entité et en utilisant la convention de nommage pour désigner les paramètres et les entités produites.

Pour les entités produites par création de paramètres, la première étape du procédé comprend des actions qui consistent à construire le modèle générique en utilisant la convention de nommage de façon à assembler les entités produites.

Pour chaque entité géométrique du composant, il suffit généralement de créer les paramètres dans deux plans orthogonaux pour définir, par projection inverse, l'entité dans un espace tridimensionnel. La figure 2 présentant par exemple une projection de la traverse dans un plan horizontal, le paramètre de hauteur 29 relatif à la boîte d'écrasement 24, est défini par projection dans un premier plan vertical et le paramètre de hauteur 30 relatif à la poutre 22, est défini par projection dans un deuxième plan vertical identique ou perpendiculaire au premier plan vertical. La combinaison des projections inverses permet alors d'obtenir la forme tridimensionnelle représentée en figure 3.

Le modèle générique peut encore être obtenu à partir d'un modèle qui, sans être suffisamment complet pour constituer le modèle générique de l'invention, est déjà un modèle paramétré au sens des valeurs géométriques. Les actions consistant à produire les entités du modèle génériques se contentent alors de désigner les paramètres en conformité avec la convention de nommage qui convient à l'exécution des étapes suivantes du procédé.

Il convient déjà d'utiliser la convention de nommage dans la première étape pour des actions qui consistent à établir ou compléter des règles de contrôle sur les valeurs admissibles des paramètres.

Les valeurs admissibles des paramètres peuvent résulter de contraintes purement géométriques. Par exemple sur la figure 2, pour fixer une valeur du paramètre 31, on comprend qu'on ne peut augmenter la valeur du paramètre 27 au-delà d'une limite dont le franchissement provoque nécessairement une diminution du paramètre 31 sauf à augmenter suffisamment la valeur du paramètre 32, du paramètre 23 ou du paramètre 28. Une table des paramètres contenant une première variable associée à chaque paramètre pour déterminer sa valeur, contient aussi deux autres variables associées pour imposer une limite basse et une limite haute de la valeur du paramètre. Les deux limites sont elles-mêmes limitées à un minimum et à un maximum. Une règle de contrôle relative à la géométrie, est associée dans la table à la première variable pour augmenter la limite basse et diminuer la limite haute en fonction des valeurs d'autres paramètres géométriques.

Les valeurs admissibles des paramètres peuvent résulter de contraintes de fabrication. Par exemple la nature du matériau utilisé peut imposer une épaisseur minimale en termes de solidité et une épaisseur maximale en termes de poids et de déformabilité nécessaire au processus de mise en forme matérielle par emboutissage ou autre. Par exemple encore, la nature du matériau peut imposer une surface de contact minimale entre deux entités pour garantir la fixation de l'une à l'autre et un volume maximal en termes de masses. D'autres contraintes de fabrication peuvent imposer des valeurs minimales et maximales ou encore des lois de variations liées entre certains paramètres géométriques pour des questions de montage, d'outillage ou autres. On associe alors une règle de contrôle relative à la fabrication, dans la table à la première variable pour augmenter la limite basse, diminuer la limite haute ou moduler un coefficient de variation en fonction des valeurs d'autres paramètres géométriques ou de grandeurs physiques caractéristiques des matériaux utilisés.

Les valeurs admissibles des paramètres peuvent résulter d'autres contraintes, par exemple de contraintes législatives en termes de normalisation, de consommation d'énergie, de sécurité ou autres, de contraintes économiques en termes de coût de la matière, de transport ou autres, ou de contraintes dans d'autres domaines divers et variés. On associe alors une règle de contrôle relative à chaque contrainte, dans la table à la première variable pour augmenter la limite basse, diminuer la limite haute ou moduler un coefficient de variation en fonction des valeurs d'autres paramètres géométriques ou de critères dimensionnels imposés par ces autres contraintes.

Le paramétrage est orienté par les concepteurs grâce à l'expérience acquise par les métiers lors d'études précédentes. Le modèle paramétré est dynamique et peut intégrer à tout moment des paramètres ou des formes différentes. Compte tenu du manque de visibilité au début de l'étude, un premier type de géométrie est principalement utilisé pendant la phase exploratoire du projet. La géométrie définitive de la pièce est généralement redessinée ensuite en phase aval et le plus souvent par le fournisseur qui a à sa charge la réalisation physique. Néanmoins, les côtes dimensionnant la forme finie de la pièce sont issues du procédé ici exposé.

La génération des configurations à calculer est pilotée à partir d'une table de paramètres. Il suffit à l'utilisateur de modifier la valeur d'un ou plusieurs paramètres pour modifier la forme.

Ainsi, la création d'un modèle générique prend en compte le plus grand nombre possible de paramètres de forme, permet la génération de typologies de traverse existantes et intègre des paramètres liés au processus de fabrication. L'ajout d'éléments géométriques dans les zones d'interfaçage avec les autres pièces, par exemple des longerons, prépare l'intégration du modèle relatif au composant dans un modèle de calcul global, en d'autres termes dans un modèle relatif au système dont le composant fait partie. Des entités géométriques sont ajoutées à la géométrie avant d'exploiter le modèle, notamment dans le lancement d'une boucle de calcul numérique comme nous le verrons par la suite.

Il convient aussi d'utiliser la convention de nommage dans la première étape pour des actions qui consistent à élaborer une ou plusieurs spécifications de simulation de manière applicable aux entités.

On peut élaborer la ou les spécifications conformes à l'invention à partir de spécifications existantes qui couvrent déjà d'autres modélisations. On peut aussi, indépendamment ou en combinaisons avec la possibilité d'élaboration précédente, élaborer la ou les spécifications de toute pièce en synthétisant des connaissances métier liées à la technologie du composant et/ou des connaissances métier liées à la simulation numérique.

La spécification formelle intégrée au modèle générique, comprend des préconisations qui permettent une mise en données de chaque modèle individuel pour un comportement de composant modélisé déterminé ou en d'autres termes sélectionné.

Des préconisations sont relatives à des zones spécifiques matérialisées par des surfaces pour l'installation d'éléments rigides, par exemple RBODY (corps rigide) en écrasement.

D'autres préconisations sont relatives à des points s'appuyant sur la surface pour générer les points de soudure (PSR pour point de soudure résistive) en écrasement, en statique linéaire et analyse vibratoire.

D'autres préconisations encore sont relatives à des points de la surface pour spécifier les points de contrôle nécessaires au post-traitement, par exemple THNOD (acronyme de l'expression anglaise Node Of Displacement) en écrasement.

En fonction des besoins de simulation, on incorpore à la spécification formelle, des préconisations relatives à des bandes de surface pour la création de cordons de soudure.

On met aussi en place où c'est utile, des préconisations de positionnement de triplets de points dans l'espace pour la création de repères locaux, notamment utilisés pour indiquer une direction d'effort ou une orientation de ressort.

Des préconisations relatives à des désignations de pièces extérieures au composant permettent d'affecter à chacune d'elles un numéro d'identifiant spécifique utilisable pour l'intégration d'un sous modèle dans un modèle complet de façon à éviter le risque de doublons des numéros de PID (Acronyme de l'expression anglaise Piece Identification Désignation).

Des préconisations relatives à des surfaces spécifiques, sont utiles pour créer des jeux (sets en anglais) d'efforts comme par exemple le jeu relatif à une application de force uniformément répartie, à un déplacement imposé, ou autre.

On peut aussi incorporer dans la spécification, des préconisations qui sont relatives à des surfaces appartenant au composant pour la mise en place de zones de masticage ou de sertissage.

La liste de préconisations énumérées ci-dessus, est donnée à titre purement illustratif et non exhaustif.

Une spécification peut contenir d'autres préconisations comme par exemple les préconisations liées à une étude de comportement particulier.

Une spécification relative à un comportement en écrasement contient par exemple des préconisations de maillage tétraédrique ou hexaédrique pour des volumes et des préconisations de maillage en tétragones pour des surfaces avec des tailles de mailles minimales et maximales.

Une spécification relative à un comportement vibratoire contient par exemple d'autres préconisations de maillage tétraédrique ou hexaédrique pour des volumes et des préconisations de maillage en tétragones ou en trigones pour des surfaces avec d'autres tailles de mailles minimales et maximales.

On met en place un nommage des préconisations de ces spécifications pour renseigner des séquences d'instructions de lancement automatique de maillage et de mise en données du modèle. On rappelle que les préconisations sont écrite en un langage formel directement interprétable par une machine.

Ainsi une spécification relative à un comportement en écrasement contient par exemple une valeur de limite d'élasticité relative au matériau de la poutre 22 qui est nommée de manière semblable au paramètre 23 mais où la chaîne de caractères désignant une profondeur est remplacée par une chaîne de caractères désignant une limite d'élasticité. La spécification relative au comportement en écrasement contient par exemple encore une valeur de contrainte de cisaillement relative au matériau de la boîte d'écrasement 24 est nommé de manière semblable au paramètre 29 mais où la chaîne de caractères désignant une hauteur est remplacée par une chaîne de caractère désignant un coefficient de cisaillement.

Ainsi une spécification relative à un comportement en vibrations contient par exemple une valeur de module d'Young relative au matériau de la poutre 22 qui est nommée de manière semblable au paramètre 32 mais où la chaîne de caractères désignant une longueur est remplacée par une chaîne de caractères désignant un module d'Young. La spécification relative au comportement en vibrations contient par exemple encore une valeur de masse relative au matériau de la boîte d'écrasement 24 qui est nommée de manière semblable au paramètre 25 mais où la chaîne de caractères désignant une demi-largeur est remplacée par une chaîne de caractères désignant une masse.

Une deuxième étape du procédé consiste à établir une ligne de valeurs attribuables aux paramètres géométriques du modèle, pour chaque configuration du composant dont on veut étudier un comportement, en écrasement, en vibration ou autre. Si plusieurs configurations candidates au calcul sont prévues, il est possible d'automatiser la génération de ces configurations. Il suffit de définir une table de paramètres et d'associer les valeurs pour chaque paramètre, une macro-commande disponible dans l'outil CAO générera de manière automatique les fichiers qui serviront au transfert vers l'outil de maillage et setup de calcul.

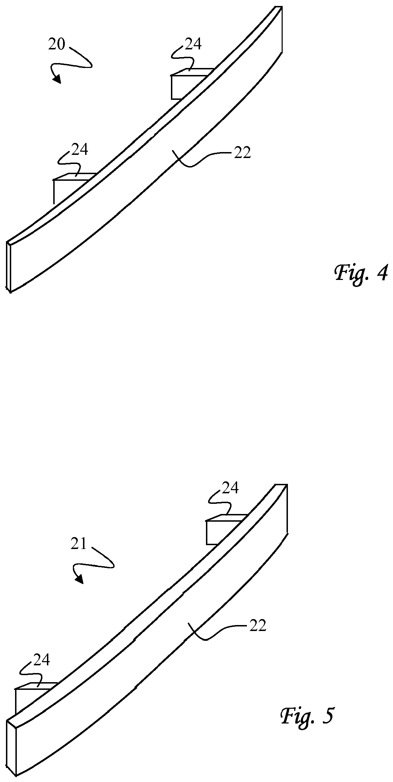

Les figures 4 et 5 présentent chacune un exemple de typologie générée à partir de l'unique modèle générique de la figure 3. On note qu'une valeur plus faible au paramètre 23 a été donnée au modèle individuel de traverse 20 de la figure 4 qu'au modèle individuel de traverse 21 de la figure 5.

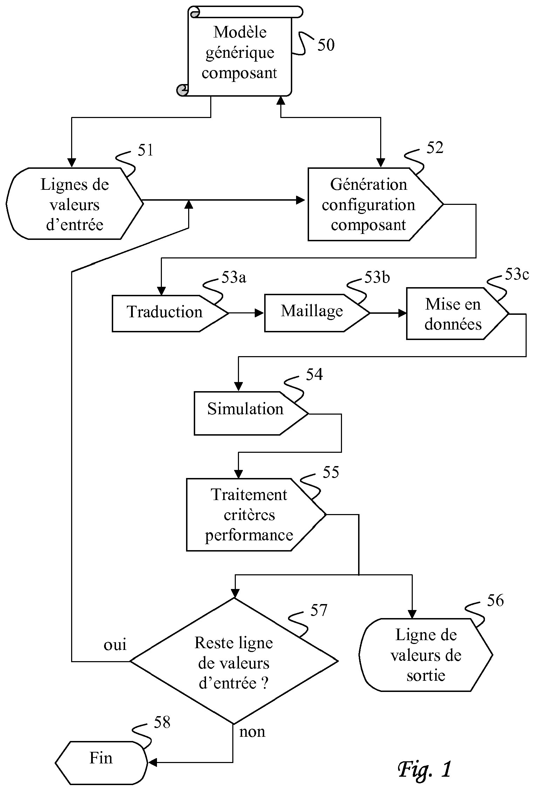

Le procédé comprend une troisième étape qui consiste à soumettre le modèle générique obtenu et la ou les lignes de valeurs établies à une machine décrite à présent en référence à la figure 1.

La machine selon l'invention permet d'évaluer de manière automatique un comportement d'une ou plusieurs configurations de tout composant pour lequel il existe un modèle de conception assistée par ordinateur. Le composant est par exemple la traverse extrême avant de véhicule dont nous venons de parler ci-dessus à titre illustratif. Le composant est par exemple encore une traverse extrême arrière étudiée en écrasement, une traverse de poste de conduite étudiée en écrasement ou en vibration, une implantation de raidisseurs dans des portes du véhicule étudiée en écrasement (crash en anglais) lors de chocs latéraux, de doublure de capot en étude d'écrasement, de raideur ou de surcourse.

La machine présentée en figure 1 permet ainsi d'enchaîner sans intervention humaine les étapes de construction d'un modèle de calcul à partir d'un modèle générique sous un logiciel de CAO (Conception Assistée par Ordinateur).

La machine comprend d'une part une zone mémoire 50 pour contenir le modèle générique du composant. Comme nous l'avons vu ci-dessus, le modèle générique comporte des paramètres, des règles de contrôle de valeurs des paramètres et une spécification de simulation d'au moins un comportement du composant en fonction des paramètres. La zone mémoire est structurée en conséquence.

Notamment, la structure de la mémoire permet d'affecter les paramètres à des entités du composant en suivant la convention de nommage partagée par les règles de contrôle et par la spécification de simulation.

La spécification de simulation comporte des lois physiques de comportement en écrasement et/ou des lois physiques de comportement vibratoire.

La machine comprend d'autre part essentiellement un enchaînement (script en anglais) de trois séquences d'instructions informatiques exécutables de manière automatique après avoir chargé le modèle générique dans la zone mémoire 50.

Une première séquence d'instructions informatiques 52 génère de manière automatique au moins un et particulièrement utilement plusieurs modèles individuels associés chacun à une configuration du composant dont on veut connaître le comportement en écrasement, en vibratoire ou autre. Les instructions exécutées par la machine lisent chaque ligne de valeurs d'entrée correspondant à une configuration du composant. Pour chaque paramètre auquel correspond une valeur d'entrée, les instructions informatiques utilisent la convention de nommage pour retrouver la ou les règles de contrôle sur les valeurs admises du paramètre de façon à contrôler, toujours de manière automatique, les valeurs de configuration avant de les affecter aux paramètres du modèle générique.

Une deuxième séquence d'instructions informatiques lance une simulation numérique d'un comportement sélectionné de chaque modèle individuel généré par la première séquence qui présente un intérêt à être simulé. La séquence d'instructions informatiques de lancement automatique de la simulation numérique comprend essentiellement quatre ensembles d'instructions dont au moins deux ensembles utilisent la spécification jointe au modèle générique.

Un premier ensemble 53a contient des instructions informatiques de traduction qui permettent de transcrire automatiquement le modèle individuel tel qu'il est généré par la première séquence d'instructions, dans un format lisible par la suite de la séquence d'instructions informatiques de lancement de la simulation numérique. La traduction de la géométrie réalisée par l'enchaînement (script en anglais) des instructions de l'ensemble 53a, est utilisable en mode de traitement par lot (batch en anglais) ou interactif. Les éléments nécessaires à la modélisation, le nommage des pièces, les identifiants de surfaces préparés dans l'outil CAO sont transférés également.

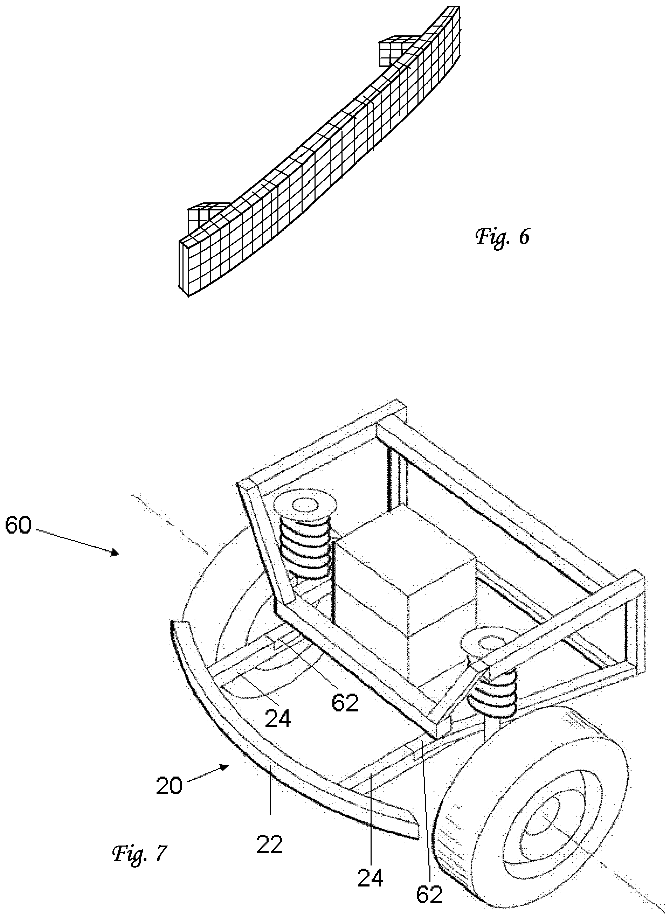

Un deuxième ensemble 53b d'instructions informatiques fait lire la géométrie définie par le modèle individuel à un logiciel de maillage. Les instructions du deuxième ensemble sont programmées de façon à retrouver dans la spécification jointe au modèle générique, les préconisations de maillage qui conviennent au comportement étudié. La spécification de simulation contient à ce titre des instructions qualificatives de maillage relatives à la topologie et à la taille des mailles qui permettent d'obtenir un calcul par éléments finis optimisé pour le type de comportement sélectionné. L'enchaînement d'instructions (sript en anglais) permet ainsi d'automatiser la génération du maillage et un contrôle de la qualité des éléments finis, facilement modifiables et transposables vers une autre application métier. L'exécution automatique du deuxième ensemble d'instructions 53b aboutit au modèle individuel maillé représenté sur la figure 6.

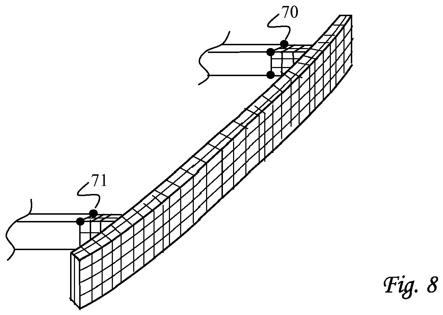

Un troisième ensemble 53c d'instructions informatiques effectue de manière automatique une mise en données du modèle individuel à partir de la spécification de simulation pour fournir un modèle spécifique à la simulation numérique tel que par exemple celui représenté en figure 8. Dans le cadre de la mise en données, on voit sur la figure 8 une mise en place de conditions limites 70, 71 qui dépendent de la physique et de la pièce à calculer telle qu'elle sera utilisée pour l'évaluation de la prestation. Traitée en mode par lots (batch en anglais), la tâche liée à l'exécution du troisième ensemble d'instructions, est transparente pour l'utilisateur du procédé sans réadaptation majeure du modèle global existant.

Une exécution séquentielle en série des trois ensembles d'instructions 53a, 53b et 53c a été représentée sur la figure 1. On comprendra que l'ensemble d'instructions 53c relatif à la mise en données peut faire l'objet d'une exécution en tout ou en partie, parallèle ou antérieure à l'exécution des ensembles d'instructions 53a et 53b.

Le développement des enchaînements d'instructions (scripts en anglais) des trois ensembles ci-dessus décrits, est spécifique à chaque modélisation et sa physique associée (écrasement, NVH, mécanique des fluides...). Pour construire de manière rapide, ces scripts, on dispose d'une bibliothèque de programmes qui permettent d'installer les éléments nécessaires à la boucle numérique. Le script final est alors composé de ces lignes de codes qui s'enchaineront de manière séquentielle lors du déroulement du calcul. Cette structure est ouverte également à l'intégration d'un modèle simple (sous-modèle) dans un modèle complet tel qu'expliqué à présent en référence à la figure 7.

On reconnaît ici la traverse 20 de la figure 4 avec les boîtes d'écrasement 24 reliées à des longerons 62 d'un système de train avant 60 de véhicule automobile.

Un quatrième ensemble 54 d'instructions informatiques, active de manière automatique un logiciel de simulation par éléments finis. La simulation réalise un calcul permettant d'évaluer le niveau de performance de la traverse, ou plus généralement du composant, dans son environnement.

Une troisième séquence d'instructions informatiques 55 produit à partir de la simulation, ici encore de manière automatique, une ou plusieurs valeurs d'évaluation du comportement sélectionné de la configuration à laquelle est associé le modèle individuel. La masse et les critères de performances en écrasement de chaque configuration de traverse sont mis sous contrôle de manière automatique. Les résultats sont immédiatement accessibles sans préparation préalable. Notamment, la séquence d'instructions informatiques de traitement 55 produit la ou les valeurs d'évaluation du comportement de la configuration en comparant des résultats de la simulation à des critères de performance contenus dans la spécification de simulation jointe au modèle générique.

Des modules 57 à 58 sont prévus pour gérer l'application automatique des trois séquences d'instructions informatiques exposées ci-dessus à l'ensemble des lignes de valeurs d'entrée, chacune spécifique à un modèle individuel associé à une configuration du composant jusqu'à obtenir la totalité des performances qui résultent des comportements simulés des différentes configurations du composant.

La figure 1 illustre un enchaînement de toutes les séquences d'instructions ligne après ligne en sortant un résultat de performance pour chaque ligne avant de passer à la ligne suivante.

En fait, les séquences d'instructions informatiques et notamment les logiciels qu'elles amorcent, ne sont pas nécessairement exécutées dans les mêmes ordinateurs ni dans les mêmes environnements logiciels, ni avec la même rapidité.

On préfère alors ordonnancer l'exécution des trois séquences d'instruction de la manière suivante.

La première séquence d'instruction génère de manière automatique les configurations du composant de la première à la dernière ligne d'entrée en stockant au fur et à mesure chaque modèle individuel de configuration dans un fichier informatique.

La deuxième séquence d'instructions lance de manière automatique et indépendante de la première séquence les simulations des modèles individuels en chargeant dans un ordinateur successivement l'un des fichiers stockés par la première séquence. Si le rythme des fichiers stockés par la première séquence, est plus rapide que celui d'une simulation par un ordinateur, la deuxième séquence peut répartir le chargement des fichiers de modèles individuels sur plusieurs ordinateurs de simulations. Le ou les ordinateurs de simulation stockent à leur tour les résultats de chaque simulation dans un fichier informatique.

La troisième séquence d'instructions traite les critères de performance de manière automatique, dès que la deuxième séquence sort un résultat de simulation ou après que la deuxième séquence a sorti tous les résultats de simulation.

L'exécution en traitement par lots (batch en anglais) que nous venons de présenter en alternative à un traitement successif ligne à ligne comme illustré de manière simplifiée par la figure 1, offre l'avantage d'un traitement en pipeline comme sur une chaîne de montage et d'un traitement réparti pour les tâches à vitesses d'exécution différentes.

En résumé, le procédé exposé consiste essentiellement à obtenir ou construire un modèle générique auquel on ajoute des spécifications nécessaires à l'automatisation de la mise en données. La généricité du modèle CAO paramétré de départ, le rend rapidement modifiable sans recours à un concepteur expérimenté. Les compétences pour la conception et le calcul sont inscrits dans le modèle générique lui-même de sorte que son usage est permis à des personnes non spécialistes.

On notera l'avantage du modèle générique et de la machine pour l'exploiter qui est celui de disposer dès la phase amont d'un projet des outils nécessaires à la génération de pièces et à l'évaluation en performance de celles-ci par une boucle automatique calcul facile à mettre en œuvre. L'utilisation des données géométriques fournies par le modèle générique comme support à la simulation, réduit de manière remarquable les interventions manuelles de l'ingénieur calcul.

En termes d'application industrielle, l'invention a pour avantage de réduire les délais de conception, d'être utilisable par des non spécialistes en écrasement, en conception et en simulation. L'invention enseigne une méthode transverse en termes de conception, de calcul, et d'expertise qui permet de simplifier le processus de décision et d'explorer plus de solutions en amont.

## Revendications

1. Machine d'évaluation de comportement en absorption d'énergie de chocs d'une pluralité des configurations d'une traverse constituant un composant mécanique de véhicule au moyen d'au moins un logiciel de conception assistée par ordinateur, **caractérisée en ce qu'**elle comprend :
- une zone mémoire (50) contenant un modèle générique en langage formel de ladite traverse, ledit modèle générique comprenant un paramétrage de formes en associant à tout ou partie des valeurs géométriques de formes d'un modèle de base des paramètres de formes variables dans des plages prédéterminées, les valeurs géométriques de forme définissant des surfaces auxquelles on applique une fonction de nommage, ladite fonction de nommage attribuant par convention de nommage de manière arborescente un nom univoque à chaque surface, à chaque valeur de forme étant associée respectivement un des paramètres de profondeur (23), de demi-section droite (32), de demi-longueur (31), et d'angle de galbe intérieur (28) et extérieur (27) pour définir ladite traverse dans des dimensions de grandeurs géométriques, des règles de contrôle de valeurs des dits paramètres entre des limites hautes et des limites basses, et une spécification de simulation de comportement en absorption d'énergie de chocs de ladite traverse en fonction des dits paramètres ;
- une première séquence d'instructions informatiques (52) de génération automatique d'une pluralité de modèles individuels chacun associé à une configuration de ladite traverse en affectant aux paramètres du modèle générique des valeurs de configuration contrôlées par lesdites règles à partir d'au moins une ligne de valeurs d'entrée attribuables pour chaque paramètre pour chaque configuration à évaluer; avec stockage au fur et à mesure de chaque modèle individuel de configuration dans un fichier informatique ;
- une deuxième séquence d'instructions informatiques (53a, 53b, 53c, 54) de lancement de simulations numériques de comportement en absorption d'énergie de chocs des modèles individuels au moyen de ladite spécification, ladite deuxième séquence d'instructions lançant de manière automatique et indépendante de la première séquence les simulations des modèles individuels en chargeant dans un ordinateur successivement l'un des fichiers stockés par la première séquence et lorsque le rythme des fichiers stockés par la première séquence est plus rapide que celui d'une simulation par un ordinateur, la deuxième séquence répartit le chargement des fichiers des modèles individuels sur plusieurs ordinateurs de simulations, le ou les ordinateurs de simulation stockant à leur tour les résultats de chaque simulation dans un fichier informatique ; et
- une troisième séquence d'instructions informatiques (55) de traitement pour produire à partir desdites simulations une ou plusieurs valeurs d'évaluation du comportement en absorption d'énergie de chocs de chaque configuration à laquelle est associé un modèle individuel, la troisième séquence d'instructions traitant au moins un critère de performance de manière automatique, dès que la deuxième séquence sort un résultat de simulation ou après que la deuxième séquence a sorti tous les résultats de simulation.

2. Machine selon la revendication 1, **caractérisée en ce que** ladite séquence d'instructions informatiques de lancement comprend un ensemble d'instructions informatiques de maillage (53b) dudit modèle individuel et un ensemble d'instructions informatiques d'activation d'un logiciel de simulation (54) par éléments finis et **en ce que** la spécification de simulation contient des instructions qualificatives de maillage.

3. Machine selon la revendication 2, **caractérisée en ce que** ladite séquence d'instructions informatiques de lancement comprend un ensemble d'instructions informatiques de traduction (53a) pour transcrire automatiquement le modèle individuel tel qu'il est généré dans un format lisible par la suite de la séquence d'instructions informatiques de lancement de la simulation numérique.

4. Machine selon l'une des revendications précédentes, **caractérisée en ce que** ladite séquence d'instructions informatiques de lancement comprend un ensemble d'instructions informatiques de mise en données (53c) du modèle individuel à partir de la spécification de simulation pour fournir un modèle spécifique à la simulation numérique.

5. Machine selon l'une des revendications précédentes, **caractérisée en ce que** la spécification de simulation comporte des lois physiques de comportement en écrasement.

6. Machine selon l'une des revendications précédentes, **caractérisée en ce que** ladite séquence d'instructions informatiques de traitement (55) produit la ou les valeurs d'évaluation du comportement de chaque configuration, en comparant des résultats de ladite simulation à des critères de performance contenus dans ladite spécification de simulation.

7. Machine selon l'une des revendications précédentes, **caractérisée en ce qu'**elle est agencée pour affecter les paramètres à des entités de la traverse comportant au moins une poutre et une boîte d'écrasement, en suivant une convention de nommage partagée par les règles de contrôle et la spécification de simulation.

8. Procédé d'évaluation de comportement en absorption d'énergie de chocs d'une pluralité de configurations d'une traverse constituant un composant mécanique de véhicule au moyen d'au moins un logiciel de conception assistée par ordinateur, **caractérisé en ce qu'**il comprend des étapes consistant à :
- obtenir un modèle générique en langage formel de ladite traverse, la construction dudit modèle générique comprenant un paramétrage de formes en associant à tout ou partie des valeurs géométriques de formes d'un modèle de base, des paramètres de formes variables dans des plages prédéterminées, les valeurs géométriques de forme définissant des surfaces auxquelles on applique une fonction de nommage, ladite fonction de nommage attribuant par convention de nommage de manière arborescente un nom univoque à chaque surface, à chaque valeur de forme est associée respectivement un des paramètres de profondeur (23), de demi-section droite (32), de demi-longueur (31), et d'angle de galbe intérieur (28) et extérieur (27), pour définir ladite traverse dans des dimensions de grandeurs géométriques, des règles de contrôle de valeurs des dits paramètres entre des limites hautes et des limites basses, et une spécification de simulation de comportement en absorption d'énergie de chocs de ladite traverse en fonction des dits paramètres ;
- établir une ligne de valeurs attribuables pour chaque paramètre pour chaque configuration à évaluer ;
- soumettre le modèle générique obtenu et la ou les lignes de valeurs établies à une machine comprenant :
- une première séquence d'instructions informatiques (52) de génération automatique d'une pluralité de modèles individuels chacun associé à une configuration de ladite traverse en affectant aux paramètres du modèle générique des valeurs de configuration contrôlées par lesdites règles à partir d'au moins une ligne de valeurs d'entrée, avec stockage au fur et à mesure de chaque modèle individuel de configuration dans un fichier informatique ;
- une deuxième séquence d'instructions informatiques (53a, 53b, 53c, 54) de lancement automatique de simulations numériques de comportement en absorption d'énergie de chocs des modèles individuels au moyen de ladite spécification, ladite deuxième séquence d'instructions lançant de manière automatique et indépendante de la première séquence les simulations des modèles individuels en chargeant dans un ordinateur successivement l'un des fichiers stockés par la première séquence et lorsque le rythme des fichiers stockés par la première séquence est plus rapide que celui d'une simulation par un ordinateur, la deuxième séquence répartit le chargement des fichiers des modèles individuels sur plusieurs ordinateurs de simulations, le ou les ordinateurs de simulation stockant à leur tour les résultats de chaque simulation dans un fichier informatique ; et
- une troisième séquence d'instructions informatiques (55) de traitement pour produire à partir desdites simulations, une ou plusieurs valeurs d'évaluation du comportement en absorption d'énergie de chocs de chaque configuration à laquelle est associé un modèle individuel, la troisième séquence d'instructions traitant au moins un critère de performance de manière automatique, dès que la deuxième séquence sort un résultat de simulation ou après que la deuxième séquence a sorti tous les résultats de simulation.

9. Procédé d'évaluation de comportement d'une pluralité des configurations de ladite traverse selon la revendication 8, **caractérisé en ce que** l'étape consistant à obtenir le modèle générique comprend des actions consistant à :
- produire au moyen d'un premier logiciel de conception assistée par ordinateur des entités de type boîte d'écrasement par création de paramètres comprenant des paramètres les valeurs de forme d'une demi-largeur prise à partir d'une ligne de centrage située à distance déterminée d'une extrémité de la traverse (22), en identifiant les paramètres et les entités produites au moyen de la convention de nommage ;
- établir les règles de contrôle en les associant, au moyen de la convention de nommage, aux entités produites ;
- construire le modèle générique en assemblant, au moyen de la convention de nommage, les entités produites, par création des paramètres dans deux plans orthogonaux pour définir, par projection inverse, l'entité dans un espace tridimensionnel.

10. Procédé d'évaluation de comportement d'une pluralité des configurations de ladite traverse selon la revendication 9, **caractérisé en ce que** l'étape consistant à obtenir le modèle générique comprend une ou plusieurs actions consistant à :
- élaborer la spécification de simulation, de manière applicable aux entités au moyen de la convention de nommage.

11. Procédé d'évaluation de comportement d'une pluralité des configurations de ladite traverse selon l'une des revendications 8 à 10, **caractérisé en ce que** les paramètres comportent des paramètres de formes géométriques et **en ce que** le modèle générique comporte une structure arborescente d'entités comprenant des points, des lignes, des surfaces et/ou des volumes.

12. Procédé d'évaluation de comportement d'une pluralité des configurations de ladite traverse selon l'une des revendications 8 à 11, **caractérisé en ce que** la spécification de simulation contient des instructions qualificatives de maillage.

## Patentansprüche

1. Maschine zur Bewertung eines Aufprallenergieabsorptionsverhaltens einer Vielzahl der Konfigurationen eines Querträgers, der ein mechanisches Fahrzeugbauteil bildet, mittels mindestens einer computergestützten Design-Software, **dadurch gekennzeichnet, dass** sie enthält:
- eine Speicherzone (50), die ein generisches Modell in formaler Sprache des Querträgers enthält, wobei das generische Modell eine Parametrierung von Formen, indem allen oder einem Teil der geometrischen Werte von Formen eines Basismodells in vorbestimmten Bereichen variable Parameter von Formen zugeordnet werden, wobei die geometrischen Formparameter Flächen definieren, an die eine Benennungsfunktion angewendet wird, wobei die Benennungsfunktion durch Benennungskonvention baumförmig jeder Fläche einen eineindeutigen Namen zuweist, wobei jedem Formwert einer der Tiefen-(23), Halbquerschnitts- (32), Halblängen- (31) bzw. inneren (28) und äußeren Rundungswinkelparameter (27) zugeordnet ist, um den Querträger in Abmessungen geometrischer Größen zu definieren, Kontrollregeln von Werten der Parameter zwischen Obergrenzen und Untergrenzen, und eine Simulationsspezifikation eines Aufprallenergieabsorptionsverhaltens des Querträgers abhängig von den Parametern enthält;
- eine erste Sequenz von Computerbefehlen (52) zur automatischen Generierung einer Vielzahl von Einzelmodellen, die je einer Konfiguration des Querträgers zugeordnet sind, indem den Parametern des generischen Modells ausgehend von mindestens einer Reihe von Eingangswerten, die für jeden Parameter für jede zu bewertende Konfiguration zuteilbar sind, von den Regeln kontrollierte Konfigurationswerte zugewiesen werden; mit Speicherung jedes Konfigurations-Einzelmodells nacheinander in einer Datei;
- eine zweite Sequenz von Computerbefehlen (53a, 53b, 53c, 54) zum Start digitaler Simulationen eines Aufprallenergieabsorptionsverhaltens der Einzelmodelle mittels der Spezifikation, wobei die zweite Befehlssequenz automatisch und unabhängig von der ersten Sequenz die Simulationen der Einzelmodelle startet, indem aufeinanderfolgend eine der von der ersten Sequenz gespeicherten Dateien in einen Computer geladen wird, und wenn der Rhythmus der von der ersten Sequenz gespeicherten Dateien schneller ist als derjenige einer Simulation durch einen Computer, die zweite Sequenz das Laden der Dateien der Einzelmodelle auf mehrere Simulationscomputer verteilt, wobei der oder die Simulationscomputer ihrerseits die Ergebnisse jeder Simulation in einer Datei speichern; und
- eine dritte Sequenz von Verarbeitungs-Computerbefehlen (55), um ausgehend von den Simulationen einen oder mehrere Bewertungswerte des Aufprallenergieabsorptionsverhaltens jeder Konfiguration zu produzieren, der ein Einzelmodell zugeordnet ist, wobei die dritte Befehlssequenz mindestens automatisch ein Leistungskriterium verarbeitet, sobald die Sequenz ein Simulationsergebnis ausgibt oder nachdem die zweite Sequenz alle Simulationsergebnisse ausgegeben hat.

2. Maschine nach Anspruch 1, **dadurch gekennzeichnet, dass** die Sequenz von Start-Computerbefehlen eine Einheit von Vernetzungs-Computerbefehlen (53b) des Einzelmodells und eine Einheit von Aktivierungs-Computerbefehlen einer Software der Simulation (54) durch finite Elemente enthält, und dass die Simulationsspezifikation maßgebende Vernetzungsbefehle enthält.

3. Maschine nach Anspruch 2, **dadurch gekennzeichnet, dass** die Sequenz von Start-Computerbefehlen eine Einheit von Übersetzungs-Computerbefehlen (53a) enthält, um das Einzelmodell wie generiert in ein von der Folge der Sequenz von Start-Computerbefehlen der digitalen Simulation lesbares Format umzuschreiben.

4. Maschine nach einem der vorhergehenden Ansprüche, **dadurch gekennzeichnet, dass** die Sequenz von Start-Computerbefehlen eine Einheit von Computerbefehlen zur Umwandlung in Daten (53c) des Einzelmodells ausgehend von der Simulationsspezifikation enthält, um ein für die digitale Simulation spezifisches Modell zu liefern.

5. Maschine nach einem der vorhergehenden Ansprüche, **dadurch gekennzeichnet, dass** die Simulationsspezifikation physikalische Gesetze des Knautschverhaltens aufweist.

6. Maschine nach einem der vorhergehenden Ansprüche, **dadurch gekennzeichnet, dass** die Sequenz von Verarbeitungs-Computerbefehlen (55) den oder die Bewertungswerte des Verhaltens jeder Konfiguration erzeugt, indem Ergebnisse der Simulation mit Leistungskriterien verglichen werden, die in der Simulationsspezifikation enthalten sind.

7. Maschine nach einem der vorhergehenden Ansprüche, **dadurch gekennzeichnet, dass** sie eingerichtet ist, um die Parameter Entitäten des Querträgers zuzuweisen, die mindestens einen Balken und eine Knautschbox aufweisen, gemäß einer Benennungskonvention, die von den Kontrollregeln und der Simulationsspezifikation geteilt wird.

8. Verfahren zur Bewertung eines Aufprallenergieabsorptionsverhaltens einer Vielzahl von Konfigurationen eines Querträgers, der ein mechanisches Fahrzeugbauteil bildet, mittels mindestens einer computergestützten Design-Software, **dadurch gekennzeichnet, dass** es Schritte enthält, die darin bestehen:
- ein generisches Modell in formaler Sprache des Querträgers zu erhalten, wobei die Konstruktion des generischen Modells eine Parametrierung von Formen, indem allen oder einem Teil der geometrischen Formparameter eines Basismodells in vorbestimmten Bereichen variable Formparameter zugeordnet werden, wobei die geometrischen Formparameter Flächen definieren, an die eine Benennungsfunktion angewendet wird, wobei die Benennungsfunktion durch Benennungskonvention baumförmig jeder Fläche einen eineindeutigen Namen zuweist, wobei jedem Formwert einer der Tiefen- (23), Halbquerschnitts- (32), Halblängen- (31) und inneren (28) bzw. äußeren Rundungswinkelparameter (27) zugeordnet ist, um den Querträger in Abmessungen geometrischer Größen zu definieren, Kontrollregeln von Werten der Parameter zwischen Obergrenzen und Untergrenzen, und eine Simulationsspezifikation eines Aufprallenergieabsorptionsverhaltens des Querträgers abhängig von den Parametern zugeordnet sind;
- eine Reihe von zuteilbaren Werten für jeden Parameter für jede zu bewertende Konfiguration zu erstellen;
- das erhaltene generische Modell und die erstellte(n) Reihe(n) von Werten einer Maschine zu unterbreiten, die enthält:
- eine erste Sequenz von Computerbefehlen (52) zur automatischen Generierung einer Vielzahl von Einzelmodellen, die je einer Konfiguration des Querträgers zugeordnet sind, indem den Parametern des generischen Modells ausgehend von mindestens einer Reihe von Eingangswerten von den Regeln kontrollierte Konfigurationswerte zugewiesen werden, mit Speicherung jedes Konfigurations-Einzelmodells nacheinander in einer Datei;
- eine zweite Sequenz von Computerbefehlen (53a, 53b, 53c, 54) zum automatischen Start digitaler Simulationen eines Aufprallenergieabsorptionsverhaltens der Einzelmodelle mittels der Spezifikation, wobei die zweite Befehlssequenz automatisch und unabhängig von der ersten Sequenz die Simulationen der Einzelmodelle startet, indem in einen Computer nacheinander eine der von der ersten Sequenz gespeicherten Dateien geladen wird, und wenn der Rhythmus der von der ersten Sequenz gespeicherten Dateien schneller ist als derjenige einer Simulation durch einen Computer, die zweite Sequenz das Laden der Dateien der Einzelmodelle auf mehrere Simulationscomputer verteilt, wobei der oder die Simulationscomputer ihrerseits die Ergebnisse jeder Simulation in einer Datei speichern; und
- eine dritte Sequenz von Verarbeitungs-Computerbefehlen (55), um ausgehend von den Simulationen einen oder mehrere Bewertungswerte des Aufprallenergieabsorptionsverhaltens jeder Konfiguration zu erzeugen, der ein Einzelmodell zugeordnet ist, wobei die dritte Befehlssequenz mindestens automatisch ein Leistungskriterium verarbeitet, sobald die zweite Sequenz ein Simulationsergebnis ausgibt oder nachdem die zweite Sequenz alle Simulationsergebnisse ausgegeben hat.

9. Verfahren zur Verhaltensbewertung einer Vielzahl der Konfigurationen des Querträgers nach Anspruch 8, **dadurch gekennzeichnet, dass** der Schritt, der darin besteht, das generische Modell zu erhalten, Aktionen enthält, die darin bestehen:
- mittels einer ersten computergestützten Design-Software Entitäten vom Typ Knautschbox durch Erzeugung von Parametern zu produzieren, die Parameter die Formwerte einer Halbbreite enthalten, die ausgehend von einer Zentrierlinie erfasst wird, die sich in bestimmtem Abstand zu einem Ende des Querträgers (22) befindet, indem die Parameter und die produzierten Entitäten mittels der Benennungskonvention identifiziert werden;
- die Kontrollregeln zu erstellen, indem sie mittels der Benennungskonvention den produzierten Entitäten zugeordnet werden;
- das generische Modell zu konstruieren, indem mittels der Benennungskonvention die produzierten Entitäten durch Erzeugung der Parameter in zwei orthogonalen Ebenen zusammengefügt werden, um durch inverse Projektion die Entität in einem dreidimensionalen Raum zu definieren.

10. Verfahren zur Verhaltensbewertung einer Vielzahl der Konfigurationen des Querträgers nach Anspruch 9, **dadurch gekennzeichnet, dass** der Schritt, der darin besteht, das generische Modell zu erhalten, eine oder mehrere Aktionen enthält, die darin bestehen:
- die Simulationsspezifikation in an die Entitäten anwendbarer Weise mittels der Benennungskonvention zu erarbeiten.

11. Verfahren zur Verhaltensbewertung einer Vielzahl der Konfigurationen des Querträgers nach einem der Ansprüche 8 bis 10, **dadurch gekennzeichnet, dass** die Parameter Parameter geometrischer Formen aufweisen, und dass das generische Modell eine Baumstruktur von Entitäten aufweist, die Punkte, Linien, Flächen und/oder Volumen enthält.

12. Verfahren zur Verhaltensbewertung einer Vielzahl der Konfigurationen des Querträgers nach einem der Ansprüche 8 bis 11, **dadurch gekennzeichnet, dass** die Simulationsspezifikation maßgebende Vernetzungsbefehle enthält.

## Claims

1. Machine for evaluating the behaviour, in terms of absorbing energy from collisions, of a plurality of the configurations of a crossmember forming a mechanical component of a vehicle by means of at least one piece of computer-aided design software, **characterized in that** it comprises:
- a memory area (50) containing a generic model, in a formal language, of said crossmember, said generic model comprising form parameterization by associating, with all or some of the geometric form values of a basic model, form parameters which can vary in predetermined ranges, the geometric form values defining surfaces to which a naming function is applied, said naming function attributing, by a tree-like naming convention, a unique name to each surface, one of the depth (23), half-cross section (32), half-length (31) and inside (28) and outside (27) curve angle parameters being associated respectively with each form value in order to define said crossmember in dimensions of geometric quantities, rules for controlling values of said parameters between upper limits and lower limits, and a specification for simulation of the behaviour, in terms of absorbing energy from collisions, of said crossmember depending on said parameters;
- a first sequence of computer instructions (52) for automatically generating a plurality of individual models, each associated with a configuration of said crossmember, by assigning, to the parameters of the generic model, configuration values controlled by said rules on the basis of at least one row of attributable input values for each parameter for each configuration to be evaluated; with each individual configuration model being stored along the way in a computer file;
- a second sequence of computer instructions (53a, 53b, 53c, 54) for launching digital simulations of the behaviour, in terms of absorbing energy from collisions, of the individual models by means of said specification, said second sequence of instructions automatically, and independently of the first sequence, launching the simulations of the individual models by consecutively loading into a computer one of the files stored by the first sequence and, when the rate of the files stored by the first sequence is faster than that of a simulation by a computer, the second sequence distributes loading the files of the individual models over several simulation computers, the one or more simulation computers storing in their turn the results of each simulation in a computer file; and
- a third sequence of processing computer instructions (55) for producing, on the basis of said simulations, one or more values of the evaluation of the behaviour, in terms of absorbing energy from collisions, of each configuration with which an individual model is associated, the third sequence of instructions automatically processing at least one performance criterion, as soon as the second sequence outputs a simulation result or after the second sequence has outputted all the simulation results.

2. Machine according to Claim 1, **characterized in that** said sequence of launching computer instructions comprises a set of computer instructions (53b) for meshing said individual model and a set of computer instructions (54) for activating a piece of finite element simulation software, and **in that** the simulation specification contains descriptive meshing instructions.

3. Machine according to Claim 2, **characterized in that** said sequence of launching computer instructions comprises a set of translating computer instructions (53a) for automatically transcribing the individual model as it is generated into a format which can be read following the sequence of computer instructions for launching the digital simulation.

4. Machine according to one of the preceding claims, **characterized in that** said sequence of launching computer instructions comprises a set of computer instructions (53c) for datafying the individual model on the basis of the simulation specification in order to provide a model which is specific to the digital simulation.

5. Machine according to one of the preceding claims, **characterized in that** the simulation specification includes physical laws on behaviour in a crash.

6. Machine according to one of the preceding claims, **characterized in that** said sequence of processing computer instructions (55) produces the one or more values of the evaluation of the behaviour of each configuration, by comparing results of said simulation with performance criteria contained in said simulation specification.

7. Machine according to one of the preceding claims, **characterized in that** it is arranged to assign the parameters to entities of the crossmember including at least a beam and a crash box, by following a naming convention shared by the control rules and the simulation specification.

8. Method for evaluating the behaviour, in terms of absorbing energy from collisions, of a plurality of configurations of a crossmember forming a mechanical component of a vehicle by means of at least one piece of computer-assisted design software, **characterized in that** it comprises steps consisting in:
- obtaining a generic model, in a formal language, of said crossmember, the construction of said generic model comprising form parameterization by associating, with all or some of the geometric form values of a basic model, form parameters which can vary in predetermined ranges, the geometric form values defining surfaces to which a naming function is applied, said naming function attributing, by a tree-like naming convention, a unique name to each surface, one of the depth (23), half-cross section (32), half-length (31) and inside (28) and outside (27) curve angle parameters is associated respectively with each form value, in order to define said crossmember in dimensions of geometric quantities, rules for controlling values of said parameters between upper limits and lower limits, and a specification for simulation of the behaviour, in terms of absorbing energy from collisions, of said crossmember depending on said parameters;
- establishing a row of attributable values for each parameter for each configuration to be evaluated;
- submitting the obtained generic model and the one or more established rows of values to a machine comprising:
- a first sequence of computer instructions (52) for automatically generating a plurality of individual models, each associated with a configuration of said crossmember, by assigning, to the parameters of the generic model, configuration values controlled by said rules on the basis of at least one row of input values, with each individual configuration model being stored along the way in a computer file;
- a second sequence of computer instructions (53a, 53b, 53c, 54) for automatically launching digital simulations of the behaviour, in terms of absorbing energy from collisions, of the individual models by means of said specification, said second sequence of instructions automatically, and independently of the first sequence, launching the simulations of the individual models by consecutively loading into a computer one of the files stored by the first sequence and, when the rate of the files stored by the first sequence is faster than that of a simulation by a computer, the second sequence distributes loading the files of the individual models over several simulation computers, the one or more simulation computers storing in their turn the results of each simulation in a computer file; and
- a third sequence of processing computer instructions (55) for producing, on the basis of said simulations, one or more values of the evaluation of the behaviour, in terms of absorbing energy from collisions, of each configuration with which an individual model is associated, the third sequence of instructions automatically processing at least one performance criterion, as soon as the second sequence outputs a simulation result or after the second sequence has outputted all the simulation results.

9. Method for evaluating the behaviour of a plurality of the configurations of said crossmember according to Claim 8, **characterized in that** the step consisting in obtaining the generic model comprises actions consisting in:
- producing, by means of a first piece of computer-aided design software, entities of crash box type by creating parameters comprising parameters the form values of a half-width taken from a centring line located at a determined distance from an end of the crossmember (22), by identifying the parameters and the produced entities by means of the naming convention;
- establishing the control rules by associating them, by means of the naming convention, with the produced entities;
- constructing the generic model by assembling, by means of the naming convention, the produced entities, by creating the parameters in two orthogonal planes in order to define, by inverse projection, the entity in a three-dimensional space.

10. Method for evaluating the behaviour of a plurality of the configurations of said crossmember according to Claim 9, **characterized in that** the step consisting in obtaining the generic model comprises one or more actions consisting in:
- developing the simulation specification, in a way which can be applied to the entities by means of the naming convention.

11. Method for evaluating the behaviour of a plurality of the configurations of said crossmember according to one of Claims 8 to 10, **characterized in that** the parameters include geometric form parameters and **in that** the generic model includes a tree-like structure of entities comprising points, lines, surfaces and/or volumes.

12. Method for evaluating the behaviour of a plurality of the configurations of said crossmember according to one of Claims 8 to 11, **characterized in that** the simulation specification contains descriptive meshing instructions.
